# EUROPEAN PATENT APPLICATION

(11) **EP 4 407 743 A1**
(43) Date of publication of application: **31.07.2024**
(21) Application number: 23212453.7
(22) Date of filing: 27.11.2023
(51) Int. Cl.: H01M 10/42, H01M 10/48, H01M 50/204, H01M 50/209, H01M 50/30, H01M 50/519, H05K 1/18

(54) **RECHARGEABLE BATTERY PACK**

(30) Priority: 09.01.2023 KR 20230002905
(71) Applicant: Samsung SDI Co., Ltd., Yongin-si, Gyeonggi-do 17084 (KR)
(72) Inventor: AHN, Jaepil, 17084 Yongin-si (KR)
(74) Representative: Marks & Clerk LLP

(57) **Abstract**

Disclosed herein is a rechargeable battery pack. The rechargeable battery pack includes: a cell assembly including at least one battery cell; a side frame configured to accommodate the cell assembly; a cell monitor circuit board installed on an upper portion of the cell assembly; and a flexible printed circuit board (FPC) electrically connected to the cell assembly to sense the battery cell, and electrically connected to the cell monitor circuit board, in which the cell monitor circuit board and the flexible printed circuit board are electrically connected to each other by an electrically conductive adhesive.

## Description

### BACKGROUND OF THE INVENTION

### (a) Field of the Invention

The present disclosure relates to a rechargeable battery pack having an enhanced electrical connection stiffness of a flexible printed circuit board and a cell monitor circuit board.

### (b) Description of the Related Art

A rechargeable battery is a battery that is charged and discharged repeatedly, unlike a primary battery. Low-capacity rechargeable batteries are used in small, portable electronic devices such as cell phones, laptop computers, and camcorders. High-capacity and high-density rechargeable batteries are used to be power sources to drive motors in hybrid and electric vehicles, or for energy storage.

The rechargeable battery includes an electrode assembly that charges and discharges current, a case that accommodates the electrode assembly and an electrolyte, and electrode terminals that are connected to the electrode assembly and extend to the outside of the case. The electrode assembly may be formed of the jellyroll type, which is formed by winding the electrodes and separator.

Meanwhile, a flexible printed circuit board (flexible printed circuit, FPC) in the related art is electrically connected to a cell monitor circuit board ((cell supervision circuit, CSC)/(cell monitor circuit. CMC)) using a connector.

However, there is a problem in that the circuitry connected to the connector is often damaged in the process of attaching and detaching the connector, which reduces the durability.

In particular, there is a problem in that when the cell monitor circuit board is installed on an upper portion of a cell module, damage such as tearing of the flexible printed circuit board occurs in the process of attaching and detaching the connector in the related art.

### SUMMARY OF THE INVENTION

The present disclosure provides a rechargeable battery pack capable of electrically connecting a flexible printed circuit board and a cell monitor circuit board with an electrically conductive adhesive without the use of a connector.

According to an embodiment of the present disclosure, the rechargeable battery pack includes: a cell assembly including at least one battery cell; a side frame configured to accommodate the cell assembly; a cell monitor circuit board installed on an upper portion of the cell assembly; and a flexible printed circuit board (FPC) electrically connected to the cell assembly to sense (e.g. configured to sense) the battery cell, and electrically connected to the cell monitor circuit board, in which the cell monitor circuit board and the flexible printed circuit board are electrically connected to each other by an electrically conductive adhesive.

The electrically conductive adhesive may include a solder or a conductive glue configured to electrically connect the flexible printed circuit board and the cell monitor circuit board.

In the cell monitor circuit board, a conductive pad portion may be formed at each end of the plurality of circuit lines and electrically connected to the flexible printed circuit board.

The conductive pad portion may protrude from the circuit line at a size greater than a width of the circuit line and may be electrically connected to the cell monitor circuit board by the electrically conductive adhesive.

The conductive pad portion may include: a first expansion pad protruding from a first side of the circuit line in a width direction of the circuit line; and a second expansion pad protruding from a second side of the circuit line in the width direction of the circuit line.

A round groove may be formed between the first expansion pad and the second expansion pad.

The electrically conductive adhesive may be applied as a cream solder to the round groove, then adhered thereto by laser heat and electrically connected to the cell monitor circuit board.

The electrically conductive adhesive may be applied as a wire solder to the round groove, then adhered thereto by laser heat and electrically connected to the cell monitor circuit board.

The plurality of circuit lines may further include a first sub-pad portion formed at a position spaced apart from the conductive pad portion and into which the electrically conductive adhesive is inserted and electrically connected to the cell monitor circuit board.

The first sub-pad portion may have a through-hole formed therein into which the electrically conductive adhesive is inserted and protruding from both sides of the circuit line in the width direction of the circuit line.

The cell monitor circuit board may have a second sub-pad portion formed thereon at a position spaced apart from the first sub-pad portion and filled with the electrically conductive adhesive to be connected to the flexible printed circuit board.

The second sub-pad portion may include a ring pad inserted to penetrate the cell monitor circuit board at a position spaced apart from the first sub-pad portion with no contact with said circuit lines, and in which a long hole is formed in the ring pad. A long hole may be formed in the ring pad.

A gas vent portion may be formed in the cell monitor circuit board at a position spaced apart from the conductive pad portion.

The gas vent portion may include a reinforcing pad electrically connected to the plurality of circuit lines at a position spaced apart from the conductive pad portion and in which a gas vent hole is formed.

The reinforcing pad may be formed at a position spaced apart from the conductive pad portion with a width greater than the width of the plurality of circuit lines, and may be formed in an oblong shape along the circuit lines.

A plurality of gas vent holes may be formed along a lengthwise direction of the reinforcing pad.

The gas vent hole may be formed to penetrate the reinforcing pad and the cell monitor circuit board together.

A surface of the electrically conductive adhesive may be coated with a conformal coating.

The conformal coating may be applied around an edge of the cell monitor circuit board to which the conductive pad portion is attached, and may be applied to a portion of the edge of the cell monitor circuit board together with a portion of the flexible printed circuit board.

At least some of the above and other features of the invention are set out in the claims.

According to an embodiment of the present disclosure, it is possible to electrically connect the flexible printed circuit board and the cell monitor circuit board using the electrically conductive adhesive such as a solder without using separate terminals, thereby enabling a stable connection while preventing open circuits caused by compression damage at the circuit connection points.

### BRIEF DESCRIPTION OF THE DRAWINGS

FIG. 1 is a perspective view schematically illustrating a rechargeable battery pack according to a first embodiment of the present disclosure.
FIG. 2 is a view of main components schematically illustrating a state in which a conductive pad portion and a first sub-pad portion are formed at a connection position between a cell monitor circuit board and a flexible printed circuit board in FIG. 1.
FIG. 3 is a view of main components schematically illustrating a state in which the flexible printed circuit board and the cell monitor circuit board in FIG. 2 are electrically connected to each other by an electrically conductive adhesive (solder).
FIG. 4 is a view of main components illustrating a state in which the conductive adhesive (solder) in FIG. 3 has been applied.
FIG. 5 is a view of main components schematically illustrating a state in which the conductive adhesive in FIG. 4 has been removed.
FIG. 6 is a view of main components schematically illustrating a state in which a conductive pad portion and a second sub-pad portion are formed at a connection position between a cell monitor circuit board and a flexible printed circuit board according to a second embodiment of the present disclosure.
FIG. 7 is a view of main components schematically illustrating a state in which a conductive pad portion and a gas vent portion are formed at a connection position between a cell monitor circuit board and a flexible printed circuit board according to a third embodiment of the present disclosure.

### DETAILED DESCRIPTION OF THE EMBODIMENTS

Hereinafter, embodiments of the present disclosure will be described in detail with reference to the accompanying drawings so that those with ordinary skill in the art to which the present disclosure pertains may easily carry out the embodiments. However, the present disclosure may be implemented in various different ways and is not limited to the embodiments described herein. In the drawings, a part irrelevant to the description will be omitted to clearly describe the present disclosure, and the same or similar constituent elements will be designated by the same reference numerals throughout the specification.

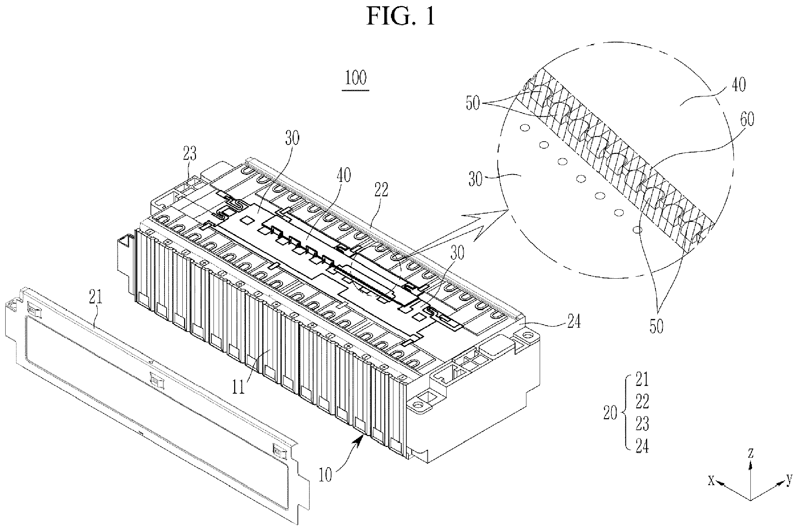

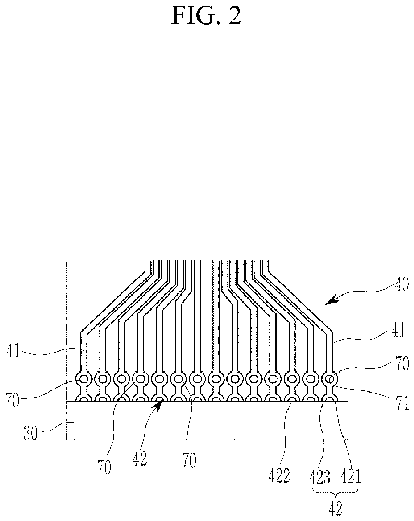

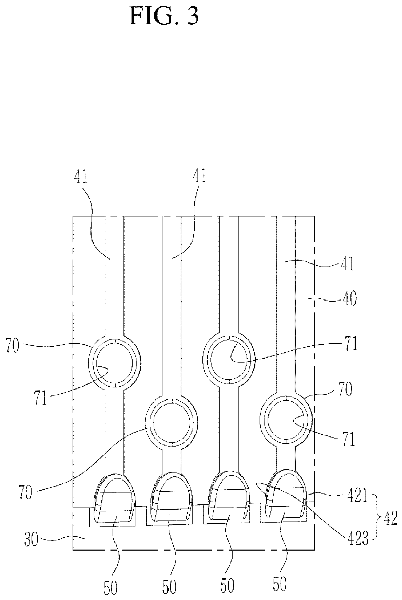

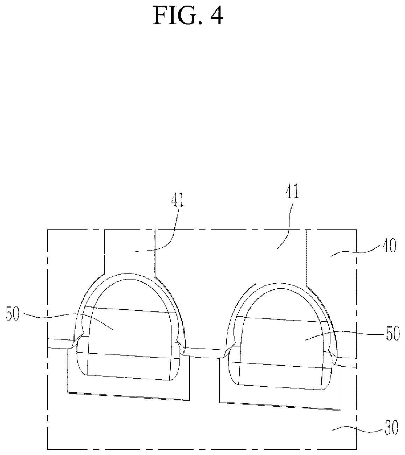

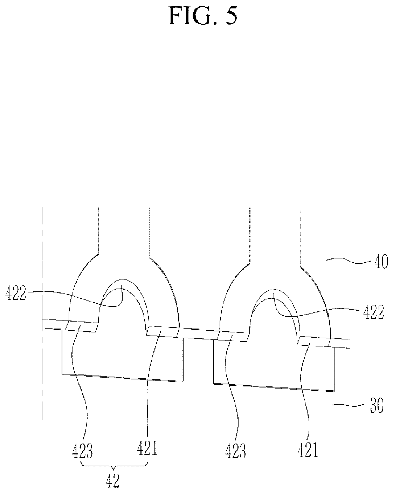

FIG. 1 is a perspective view schematically illustrating a rechargeable battery pack according to a first embodiment of the present disclosure, FIG. 2 is a view of main components schematically illustrating a state in which a conductive pad portion and a first sub-pad portion are formed at a connection position between a cell monitor circuit board and a flexible printed circuit board in FIG. 1, FIG. 3 is a view of main components schematically illustrating a state in which the flexible printed circuit board and the cell monitor circuit board in FIG. 2 are electrically connected to each other by an electrically conductive adhesive (solder), FIG. 4 is a view of main components illustrating a state in which the conductive adhesive (solder) in FIG. 3 has been applied, and FIG. 5 is a view of main components schematically illustrating a state in which the conductive adhesive in FIG. 4 has been removed.

With reference to FIGS. 1 to 5, a rechargeable battery pack 100 according to a first embodiment of the present disclosure includes a cell assembly 10 including at least one battery cell 11, a side frame 20 accommodating the cell assembly 10, a cell monitor circuit board 40 installed on an upper portion of the cell assembly 10, and a flexible printed circuit board (FPC) 30 electrically connected to the cell assembly 10 to sense a battery cell 11 and electrically connected to the cell monitor circuit board 40. Here, the flexible printed circuit board 30 and the cell monitor circuit board 40 are electrically connected to each other by an electrically conductive adhesive 50.

A plurality of battery cells 11 may be configured as a conventional rechargeable battery that is repeatedly charged and discharged.

The side frame 20 may include a first side frame 21 configured to support one side surface of the plurality of battery cells 11, a second side frame 22 configured to support the other side surface of the plurality of battery cells 11, a first end frame 23 connected at both ends thereof to respective one ends of the first side frame 21 and the second side frame 22, and a second end frame 24 connected at both ends thereof to respective the other ends of the first side frame 21 and the second side frame 22.

The first side frame 21 may be installed to support one side of the plurality of battery cells 11.

The second side frame 22 may be installed to support the other side of the plurality of battery cells 11.

The first end frame 23 may be installed to connect the respective one ends of the first side frame 21 and the second side frame 22 to connect the first side frame 21 and the second side frame 22. That is, one end of the first end frame 23 may be connected to one end of the first side frame 21 by a fastening member, and the other end of the first end frame 23 may be connected to one end of the second side frame 22 by the fastening member.

The second end frame 24 may be installed to connect the respective the other ends of the first side frame 21 and the second side frame 22 to connect the first side frame 21 and the second side frame 22. That is, one end of the second end frame 24 may be connected to the other end of the first side frame 21 by the fastening member, and the other end of the second end frame 24 may be connected to the other end of the second side frame 22 by the fastening member.

The flexible printed circuit board (FPC) 30 may be installed on an upper portion of the side frame 20, which is electrically connected to the cell assembly 10 and configured to sense the battery cells 11.

The cell monitor circuit board 40 is installed on the upper portion of the cell assembly 10.

The cell monitor circuit board 40 may be applied as a cell supervision circuit (CSC) or a cell monitor circuit (CMC).

The cell monitor circuit board 40 may be installed to receive sensing signals of the battery cell 11 through the flexible printed circuit board 30 to be capable of identifying an abnormal operating state of the battery cell 11.

The cell monitor circuit board 40 is installed on an upper side of the cell assembly 10, and may be installed in an approximately central position in a lengthwise direction of the cell assembly 10.

As described above, the cell monitor circuit board 40 may be installed in the approximately central position of the upper portion of the cell assembly 10 to allow for a reliable electrical connection while preventing interference occurring in the process of connecting the flexible printed circuit board 30 to the cell monitor circuit board 40.

The flexible printed circuit board 30 may be electrically connected at one side thereof to the cell assembly to sense the battery cells 11 and may be electrically connected at the other side thereof to the cell monitor circuit board 40.

The flexible printed circuit board 30 may be electrically connected to the cell monitor circuit board 40 that is installed at the approximately central position of the upper portion of the cell assembly 10.

The electrically conductive adhesive 50 may be applied as a solder to electrically connect the flexible printed circuit board 30 and the cell monitor circuit board 40. Alternatively, the electrically conductive adhesive 50 may be applied as a conductive glue. Hereinafter, the application of the electrically conductive adhesive 50 as a solder will be described in more detail. In the following, the electrically conductive adhesive and solder use the same reference numeral.

The cell monitor circuit board 40 may have a conductive pad portion 42 formed for solder 50 to adhere thereto.

The conductive pad portion 42 is a portion connected to the cell monitor circuit board 40 to which the solder 50 is adhered, and may be electrically connected to a circuit line 41 of the cell monitor circuit board 40.

The conductive pad portion 42 may protrude from the circuit line 41 at a size greater than a width of the circuit line 41 and be electrically connected to the flexible printed circuit board 30 by the solder 50.

With reference again to FIGS. 3 and 4, and more specifically, the conductive pad portion 42 may include a first expansion pad 421 protruding from a first side of the circuit line 41 in a width direction, and a second expansion pad 423 protruding from a second side of the circuit line 41 in a width direction. Here, the first and second sides are in opposite directions.

The first expansion pad 421 may be connected to the circuit line 41 in a state that protrudes from the circuit line 41 in a direction of the first side with respect to a center of an end of the circuit line 41.

The first expansion pad 421 is connected to the circuit line 41 with the same material as the circuit line 41 and protrudes in the direction of the first side, and may protrude from the circuit line 41 in a rounded shape.

The second expansion pad 423 may have the same or similar shape as the first expansion pad 421 and may protrude from the circuit line 41 in a direction of the second side opposite to the direction of the first side.

The second expansion pad 423 is connected to the circuit line 41 with the same material as the circuit line 41 and protrudes in the direction of the second side, and may protrude from the circuit line 41 in a rounded shape.

That is, the first expansion pad 421 and the second expansion pad 423 each protrude in a round shape in a direction opposite to each other. With a round groove 422 formed between the first expansion pad 421 and the second expansion pad 423, the first expansion pad 421 and the second expansion pad 423 may protrude while being electrically connected to the end of the circuit line 41.

As described above, the round groove 422 is formed at a position between the first expansion pad 421 and the second expansion pad 423 to provide sufficient space for the solder 50 to be filled while increasing a surface area of the portion to which the solder 50 is applied, thereby enabling a more robust electrical connection.

As described above, when the first expansion pad 421 and the second expansion pad 423 are formed at the end of the circuit line 41, the application area of the solder 50 may be maximized compared to a state in which the first expansion pad 421 and the second expansion pad 423 are not formed.

A surface of the solder 50 connecting the flexible printed circuit board 30 to the cell monitor circuit board 40 may be treated with a conformal coating 60 (see FIG. 1).

The conformal coating 60 may be applied to cover an entire outer surface of the solder 50 that is plurally cured to connect the flexible printed circuit board 30 and the cell monitor circuit board 40.

Meanwhile, a first sub-pad portion 70 may be formed on the plurality of circuit lines 41. The first sub-pad portion 70 is formed at a position spaced apart from the conductive pad portion 42 and is electrically connected to the cell monitor circuit board 40 by inserting the electrically conductive adhesive 50.

The first sub-pad portion 70 is formed to protrude from the circuit line 41 at a position spaced apart from the conductive pad portion 42 by a predetermined distance, and a through-hole 71 may be formed therein.

The first sub-pad portion 70 protrudes from the circuit line 41 in a round shape at a position spaced apart from the conductive pad portion 42, and may protrude while electrically connected to the circuit line 41.

While the first sub-pad portion 70 is illustrated as protruding from the circuit line 41 in a round shape, it is not necessarily limited thereto and may be modified to a variety of shapes, including polygonal.

Accordingly, the solder 50 is inserted into an interior of the through-hole 71 of the first sub-pad portion 70 to electrically connect the flexible printed circuit board 30 and the cell monitor circuit board 40 to each other, thereby securing a more robust electrical connection stiffness.

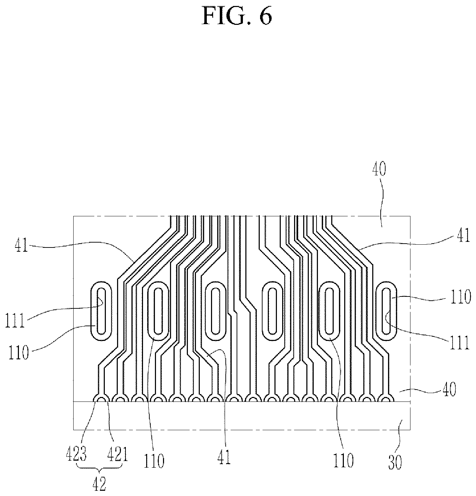

FIG. 6 is a view of main components schematically illustrating a state in which a conductive pad portion and a second sub-pad portion are formed at a connection position between a cell monitor circuit board and a flexible printed circuit board according to a second embodiment of the present disclosure. Reference numerals that are the same as those in FIGS. 1 to 5 refer to the same or similar features, the same or similar members, and the specific description thereof is omitted hereinafter.

As illustrated in FIG. 6, the cell monitor circuit board 40 of a rechargeable battery pack according to a second embodiment of the present disclosure may have a second sub-pad portion 110 formed at a position spaced apart from the conductive pad portion 42.

This second sub-pad portion 110 may be filled with the electrically conductive adhesive 50 and connected to the flexible printed circuit board 30.

More specifically, the second sub-pad portion 110 may be applied as a ring pad that is inserted to penetrate the cell monitor circuit board 40 at a position spaced apart from the first sub-pad portion 70 with no contact with the circuit line 41. Hereafter, the second sub-pad portion and the ring pad use the same reference numeral.

The ring pad 110 is formed on the cell monitor circuit board 40 at a position spaced apart from a position of the first sub-pad portion 70, and may be formed to penetrate the cell monitor circuit board 40 without being in contact with the circuit line 41.

A plurality of ring pads 110 may be inserted into the cell monitor circuit board 40 spaced apart from each other.

The ring pad 110 is elongatedly formed in a lengthwise direction along which the circuit line 41 extends and is inserted into an interior of the cell monitor circuit board 40, such that a long hole 111 may be formed in a long hole shape in the lengthwise direction. For example, the long hole 111 extends in a direction corresponding to the lengthwise direction of the circuit line 41 such that it is elongated in that direction.

The long hole 111 of the ring pad 110 is filled with the electrically conductive adhesive 50, such that the cell monitor circuit board 40 and the flexible printed circuit board 30 may be more firmly fixed to each other by an adhesive force of the electrically conductive adhesive 50.

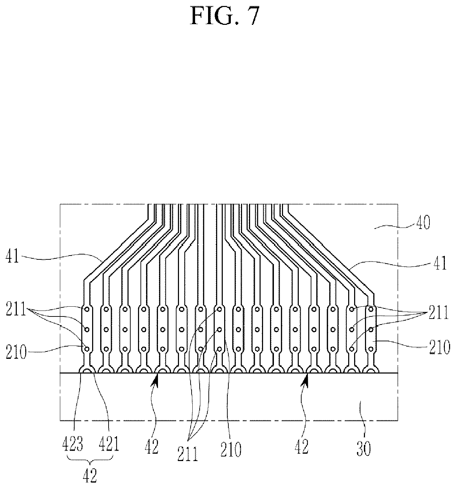

FIG. 7 is a view of main components schematically illustrating a state in which a conductive pad portion and a gas vent portion are formed at a connection position between a cell monitor circuit board and a flexible printed circuit board according to a third embodiment of the present disclosure. Reference numerals that are the same as those in FIGS. 1 to 5 refer to the same or similar features, the same or similar members, and the specific description thereof is omitted hereinafter.

As illustrated in FIG. 7, the cell monitor circuit board 40 of a rechargeable battery pack according to a third embodiment of the present disclosure may have a gas vent portion 210 formed at a position spaced apart from the conductive pad portion 42.

The gas vent portion 210 is electrically connected to the plurality of circuit lines 41 at a position spaced apart from the conductive pad portion 42 and may be applied as a reinforcing pad with a gas vent hole 211 formed therein. Hereafter, the gas vent portion and reinforcing pad use the same reference numeral.

The reinforcing pad 210 is formed on the cell monitor circuit board 40 at a position spaced apart from a position where the conductive pad portion 42 is formed, and may be formed in an oblong shape along the circuit line 41 formed on the cell monitor circuit board 40.

The reinforcing pad 210 may be elongatedly formed along the lengthwise direction of the circuit line 41 with a width greater than the width of the circuit line 41, and may be inserted into the interior of the cell monitor circuit board 40.

A plurality of gas vent holes 211 may be formed in the reinforcing pad 210.

Therefore, the gas generated in the process in which the electrically conductive adhesive is fixed may be easily discharged to the outside through the gas vent hole 211, and accordingly, the fixation force by the electrically conductive adhesive 50 is further improved, thereby improving the durability of the electrically connected cell monitor circuit board 40 and the flexible printed circuit board 30.

While the embodiments of the present disclosure have been described above, the present disclosure is not limited thereto, and various modifications can be made and carried out within the scope of the claims, the detailed description of the present disclosure, and the accompanying drawings, and also fall within the scope of the present disclosure.

### <Description of symbols>

| | | | |
|---|---|---|---|
| 10 | Cell assembly | 11 | Battery cell |
| 20 | Side frame | 21 | First side frame |
| 22 | Second side frame | 23 | First end frame |
| 24 | Second end frame | 30 | Flexible printed circuit board |
| 40 | Cell monitor circuit board | 41 | circuit line |
| 42 | Conductive pad portion | | |
| 421 | First expansion pad | 423 | Second expansion pad |
| 422 | Round groove | 50 | electrically conductive adhesive |
| 60 | conformal coating | 70 | First sub-pad portion |
| 71 | Through-hole | 110 | Second sub-pad portion |
| 111 | Long hole | 210 | Gas vent portion, Reinforcing pad |
| 211 | Gas vent hole | | |

## Claims

1. A rechargeable battery pack comprising: a cell assembly comprising at least one battery cell;
a side frame configured to accommodate the cell assembly;
a cell monitor circuit board installed on an upper portion of the cell assembly; and
a flexible printed circuit board electrically connected to the cell assembly and configured to sense the battery cell, and electrically connected to the cell monitor circuit board,
wherein the cell monitor circuit board and the flexible printed circuit board are electrically connected to each other by an electrically conductive adhesive.

2. The rechargeable battery pack of claim 1, wherein
the electrically conductive adhesive comprises:
a solder or a conductive glue configured to electrically connect the flexible printed circuit board and the cell monitor circuit board.

3. The rechargeable battery pack of claim 2, wherein
in the cell monitor circuit board, a conductive pad portion is formed at each end of the plurality of circuit lines and electrically connected to the flexible printed circuit board.

4. The rechargeable battery pack of claim 3, wherein
the conductive pad portion protrudes from the circuit line at a size greater than a width of the circuit line and is electrically connected to the cell monitor circuit board by the electrically conductive adhesive.

5. The rechargeable battery pack of claim 4, wherein
the conductive pad portion comprises:
a first expansion pad protruding from a first side of the circuit line in a width direction of the circuit line; and
a second expansion pad protruding from a second side of the circuit line in the width direction of the circuit line.

6. The rechargeable battery pack of claim 5, wherein
a round groove is formed between the first expansion pad and the second expansion pad.

7. The rechargeable battery pack of claim 6, wherein:
(i) the electrically conductive adhesive is applied as a cream solder to the round groove, then adhered thereto by laser heat and electrically connected to the cell monitor circuit board; or
(ii) the electrically conductive adhesive is applied as a wire solder to the round groove, then adhered thereto by laser heat and electrically connected to the cell monitor circuit board.

8. The rechargeable battery pack of any one of claims 3 to 7, wherein
the plurality of circuit lines further comprises a first sub-pad portion formed at a position spaced apart from the conductive pad portion and into which the electrically conductive adhesive is inserted and electrically connected to the cell monitor circuit board.

9. The rechargeable battery pack of claim 8, wherein
the first sub-pad portion has a through-hole formed therein into which the electrically conductive adhesive is inserted and protruding from both sides of the circuit line in the width direction of the circuit line.

10. The rechargeable battery pack of claim 9, wherein
the cell monitor circuit board has a second sub-pad portion formed thereon at a position spaced apart from the first sub-pad portion and filled with the electrically conductive adhesive to be connected to the flexible printed circuit board, optionally wherein:
the second sub-pad portion comprises
a ring pad inserted to penetrate the cell monitor circuit board at a position spaced apart from the first sub-pad portion with no contact with said circuit lines, and wherein
a long hole is formed in the ring pad.

11. The rechargeable battery pack of any one of claims 3 to 7, wherein
a gas vent portion is formed in the cell monitor circuit board at a position spaced apart from the conductive pad portion.

12. The rechargeable battery pack of claim 11, wherein
the gas vent portion comprises a reinforcing pad electrically connected to the plurality of circuit lines at a position spaced apart from the conductive pad portion and in which a gas vent hole is formed.

13. The rechargeable battery pack of claim 12, wherein
the reinforcing pad is formed at a position spaced apart from the conductive pad portion with a width greater than the width of the plurality of circuit lines, and is formed in an oblong shape along the circuit lines.

14. The rechargeable battery pack of claim 13, wherein
a plurality of gas vent holes are formed along a lengthwise direction of the reinforcing pad, optionally wherein:
the gas vent hole is formed to penetrate the reinforcing pad and the cell monitor circuit board together.

15. The rechargeable battery pack of any one of claims 2 to 14, wherein
a surface of the electrically conductive adhesive is coated with a conformal coating, optionally wherein:
the conformal coating is applied around an edge of the cell monitor circuit board to which the conductive pad portion is attached, and is applied to a portion of the edge of the cell monitor circuit board together with a portion of the flexible printed circuit board.
